# FASCICULE DE BREVET EUROPEEN

(11) **EP 2 701 006 B1**
(45) Date de publication et mention de la délivrance du brevet: **04.11.2015**
(21) Numéro de dépôt: 13179124.6
(22) Date de dépôt: 02.08.2013
(51) Int. Cl.: H01J 37/317, G03F 7/20, G06F 17/50, G03F 1/70, B82Y 10/00, B82Y 40/00

(54) **Procédé de préparation d'un motif à imprimer sur plaque ou sur masque par lithographie à faisceau d'électrons, système de conception de circuit imprimé et programme d'ordinateur correspondants**
Herstellungsverfahren eines Druckmotivs auf Platte oder Maske durch Elektronenstrahl-Lithografie, entsprechendes Entwurfssystem eines gedruckten Schaltkreises und entsprechendes Computerprogramm
Method for preparing a pattern to be printed on a plate or mask by electron beam lithography, corresponding printed circuit design system and computer program

(30) Priorité: 24.08.2012 FR 1257975
(43) Date de publication de la demande: 26.02.2014
(73) Titulaire: Commissariat à l'Énergie Atomique et aux Énergies Alternatives, 75015 Paris (FR); Aselta Nanographics, 38000 Grenoble (FR)
(72) Inventeur: Belledent, Jérôme, 38240 Meylan (FR)
(74) Mandataire: Bonnet, Michel

(56) Documents cités:
- WO-A2-2010/134018
- JP-A- 2009 065 036
- US-A1- 2010 183 963
- US-B1- 6 556 702
- LUC MARTIN ET AL: "Combined dose and geometry correction (DMG) for low energy multi electron beam lithography (5kV): application to the 16nm node", PROCEEDINGS OF SPIE, vol. 8323, 1 mars 2012 (2012-03-01), page 83231W-1, XP055061227, ISSN: 0277-786X, DOI: 10.1117/12.916064
- "Multi-tone rasterization, dual pass scan, data path and cell based vector format", IP.COM JOURNAL, IP.COM INC., WEST HENRIETTA, NY, US, 22 mai 2009 (2009-05-22), XP013131917, ISSN: 1533-0001
- CHRISTOPHE PIERRAT ET AL: "Mask data correction methodology in the context of model-based fracturing and advanced mask models", PROCEEDINGS OF SPIE, vol. 7973, 17 mars 2011 (2011-03-17), page 79732J-1, XP055061198, ISSN: 0277-786X, DOI: 10.1117/12.881550

## Description

La présente invention concerne un procédé de préparation d'un motif à imprimer sur plaque ou sur masque par lithographie à faisceau d'électrons. Elle concerne également un système de conception de circuit imprimé mettant en oeuvre ce procédé et un programme d'ordinateur correspondant.

Elle s'applique au domaine de la lithographie à faisceau formé réglable d'électrons, selon lequel un faisceau d'électrons émis par une machine est de forme réglable à l'aide d'équerres mobiles. La forme réglable est généralement rectangulaire et ce sont les dimensions latérales de cette forme rectangulaire qui sont réglables à l'aide des équerres.

L'invention s'applique plus particulièrement à un procédé de ce type comportant les étapes suivantes :
- modélisation du motif par décomposition de ce motif en un ensemble de formes géométriques élémentaires destinées à être imprimées individuellement par réglage de la forme du faisceau d'électron pour reproduire ledit motif, et enregistrement du modèle obtenu en mémoire, et
- pour chaque forme géométrique élémentaire du modèle, détermination, par un processeur ayant accès à la mémoire, d'une dose de charges électriques à appliquer au faisceau d'électrons lors de l'impression individuelle de cette forme géométrique élémentaire, cette dose étant choisie dans un ensemble discret de doses prédéterminées enregistrées en mémoire.

En effet, la lithographie par faisceau d'électrons ne peut pas s'affranchir d'une phase de préparation du motif à imprimer compte tenu des effets de proximité engendrés par la diffusion des électrons, des espèces chimiques dans la résine, ou autres effets susceptibles de déformer le motif à imprimer et qu'il est nécessaire de compenser. D'une façon générale, une méthode bien connue consiste à modéliser le motif par un ensemble de formes géométriques élémentaires simples, par exemple des rectangles, qui peuvent être imprimées individuellement par exposition au faisceau formé variable d'électrons pendant un certain temps (appelé temps d'exposition) chacune. L'ensemble des formes géométriques ne correspond pas précisément aux contours du motif mais en paramétrant judicieusement les temps d'exposition et en affectant pour chaque forme une dose, préalablement calculée, de charges électriques à appliquer au faisceau d'électrons pour son impression, on parvient à imprimer le motif avec une précision satisfaisante et en ayant compensé les effets précités.

Une première solution consiste plus précisément à modéliser le motif par un ensemble de formes élémentaires juxtaposées et à affecter à chaque forme élémentaire une dose et un temps d'exposition indépendants des autres. Sachant en outre qu'en pratique les doses doivent être choisies dans un ensemble discret et limité de doses prédéterminées, il est alors souvent nécessaire de multiplier les formes géométriques élémentaires et de prévoir certaines formes de petites tailles pour compenser la discrétisation des doses et obtenir une bonne précision d'impression. Or la fiabilité des équipements actuels ne permet pas d'exposer de petites formes, notamment des formes de dimensions inférieures à 10 nm. En outre, plus on augmente le nombre de formes géométriques à exposer individuellement et successivement, plus on augmente le temps global d'exposition qui représente la somme des temps individuels d'exposition des formes géométriques élémentaires du modèle.

Une autre solution est par exemple décrite dans l'article de C. Pierrat et al, intitulé « Mask data correction methodology in the context of model-base fracturing and advanced mask models », publié dans Proceedings SPIE of Optical Microlithography n° 24, vol. 7973, 1-3 mars 2011, San Jose (CA), US. Cette solution autorise la superposition des formes géométriques élémentaires de sorte que l'on peut ainsi très sensiblement réduire leur nombre et limiter les formes géométriques de petites tailles. Mais la superposition des formes rend les autres paramètres, notamment les doses de charges électriques et les temps d'exposition, dépendants les uns des autres. Cela réduit d'autant les degrés de liberté et ne permet pas nécessairement d'imprimer certaines formes géométriques complexes. En outre, cela rend les déterminations de doses nettement plus complexes, notamment parce que des surintensités locales dans les intersections de formes ne peuvent être évitées.

La demande de brevet internationale WO 2010/134018 A2, l'article de Martin et al intitulé « Combined dose and geometry correction (DMG) for low energy multi electron beam lithography (5kV) : application to the 16nm mode » publié dans Proceedings of SPIE vol. 8323 pages 83231W-1 à 83231W-10, ainsi que l'article de IP.COM Journal intitulé « Multi-tone rasterization, dual pass scan, data path, cell based vector format », divulguent la pixellisation d'un motif et l'impression successive des pixels par scan à l'aide de doses binaires affectées à des petits faisceaux multiples scannés. Mais ces documents ne concernent pas le domaine de la lithographie à faisceau formé d'électrons. Ils concernent le domaine de la lithographie « rasterscan à multiples faisceaux gaussiens non réglables, selon lequel les faisceaux d'électrons sont plus petits, appelés « beamlets », mais non formés. Dans ce domaine, le dosage d'une zone à imprimer ne peut être modulé que par pixellisation de la zone puis binarisation par tramage. La taille des pixels est généralement de l'ordre du nm, c'est-à-dire nettement inférieure à 10 nm. Plus cette taille est petite, meilleure est la précision du tramage puisqu'à chaque pixel est associée une valeur binaire de dose. Au contraire, dans le domaine de l'invention, la lithographie à faisceau formé variable d'électrons, il est souhaité que les formes géométriques élémentaires modélisant un motif soient les plus grandes possibles, notamment supérieures à 10 nm voire 20 nm, pour réduire le temps global d'exposition et pour tenir compte de l'impossibilité d'exposer de petites formes inférieures à 10 nm.

Le document US 2010/0183963 A1 divulgue un procédé de préparation d'un motif à imprimer sur plaque ou sur masque par lithographie à faisceau d'électrons, comportant les étapes suivantes :
- modélisation du motif par décomposition de ce motif en une matrice de pixels destinés à être imprimés individuellement pour reproduire ledit motif,
- pour chaque pixel du modèle, détermination d'une dose de charges électriques à appliquer au faisceau d'électrons lors de l'impression individuelle de ce pixel, cette dose étant choisie dans un ensemble discret de doses incluant plusieurs doses non nulles.

Il convient cependant de noter que ce procédé ne concerne pas non plus le domaine de la lithographie à faisceau formé réglable d'électrons, selon lequel un faisceau d'électrons émis par une machine est de forme réglable à l'aide d'équerres mobiles.

Il peut ainsi être souhaité de prévoir un procédé de préparation d'un motif à imprimer sur plaque ou sur masque par lithographie à faisceau formé variable d'électrons qui permette de s'affranchir d'au moins une partie des problèmes et contraintes précités.

Il est donc proposé un procédé de préparation d'un motif à imprimer sur plaque ou sur masque par lithographie à faisceau d'électrons, comportant les étapes suivantes :
- modélisation du motif par décomposition de ce motif en un ensemble de formes géométriques élémentaires destinées à être imprimées individuellement pour reproduire ledit motif, et enregistrement du modèle obtenu en mémoire,
- pour chaque forme géométrique élémentaire du modèle, détermination, par un processeur ayant accès à la mémoire, d'une dose de charges électriques à appliquer au faisceau d'électrons lors de l'impression individuelle de cette forme géométrique élémentaire, cette dose étant choisie dans un ensemble discret de doses incluant plusieurs doses non nulles prédéterminées enregistrées en mémoire,
dans lequel l'ensemble de formes géométriques élémentaires est un pavage bidimensionnel de formes géométriques élémentaires identiques recouvrant le motif à imprimer, et dans lequel, lors de la détermination des doses à appliquer aux formes géométriques élémentaires, une correction d'erreur de discrétisation est réalisée par tramage.

Grâce à l'invention, la modélisation spatiale du motif par l'ensemble des formes géométriques élémentaires est très fortement simplifiée. Celles-ci sont non seulement juxtaposées mais en outre identiques de manière à constituer un pavage. Ainsi, outre la discrétisation des doses dans un ensemble discret incluant plusieurs doses non nulles prédéterminées, la modélisation est elle-même simplifiée, ce qui est judicieusement compensé par une correction d'erreur de discrétisation par tramage.

De façon optionnelle, un procédé de préparation d'un motif à imprimer selon l'invention peut comporter en outre une étape de regroupement de formes géométriques élémentaires voisines dont les doses sont identiques, en des formes géométriques de tailles plus importantes destinées chacune à être imprimées en une seule exposition au faisceau d'électrons. On peut ainsi réduire fortement le nombre d'expositions successives au faisceau d'électrons et donc le temps global d'exposition.

De façon optionnelle également, un procédé de préparation d'un motif à imprimer selon l'invention peut comporter en outre une étape de modélisation préalable du motif par décomposition de ce motif en un ensemble théorique de formes géométriques de dimensions différentes associées respectivement à un ensemble de doses théoriques, et, lors de la détermination des doses à appliquer au pavage des formes géométriques élémentaires, une pixélisation préalable de l'ensemble théorique sur l'ensemble des formes géométriques élémentaires est exécutée pour déterminer des valeurs initiales des doses à appliquer aux formes géométriques élémentaires.

De façon optionnelle également, un ensemble discret de doses est utilisé lors de l'étape de modélisation préalable pour déterminer les doses théoriques, cet ensemble discret de doses étant différent de celui utilisé lors de la détermination des doses à appliquer aux formes géométriques élémentaires, notamment cet ensemble comportant moins de valeurs discrètes de doses.

De façon optionnelle également, la détermination des doses à appliquer aux formes géométriques élémentaires comporte une comparaison des valeurs initiales de doses à l'ensemble discret des doses prédéterminées enregistrées en mémoire, un choix de doses parmi cet ensemble discret et ladite correction par tramage des erreurs induites par ce choix.

De façon optionnelle également, les doses prédéterminées sont définies sous la forme d'une densité de charges électriques exprimée en nombre de charges par unité de surface.

De façon optionnelle également, la correction par tramage est réalisée à l'aide d'une matrice prédéterminée de diffusion d'erreur, notamment la matrice de diffusion de l'algorithme de Floyd-Steinberg.

De façon optionnelle également, lors de la détermination des doses à appliquer aux formes géométriques élémentaires :
- un premier ensemble discret de doses prédéterminées enregistrées en mémoire, dit ensemble grossier, est utilisé pour les formes géométriques élémentaires situées à l'intérieur du motif à imprimer, et
- un deuxième ensemble discret de doses prédéterminées enregistrées en mémoire, dit ensemble fin et comportant davantage de valeurs discrètes de doses que l'ensemble grossier, est utilisé pour les formes géométriques élémentaires situées sur le contour du motif à imprimer.

Il est également proposé un programme d'ordinateur téléchargeable depuis un réseau de communication et/ou enregistré sur un support lisible par ordinateur et/ou exécutable par un processeur, comprenant des instructions pour l'exécution des étapes d'un procédé de préparation d'un motif à imprimer par lithographie à faisceau d'électrons tel que défini précédemment, lorsque ledit programme est exécuté sur un ordinateur.

Il est également proposé un système de conception de circuit imprimé par impression de motifs sur plaque ou sur masque à l'aide d'une lithographie à faisceau d'électrons, comportant :
- une mémoire de stockage de paramètres de modélisation d'un motif par un ensemble de formes géométriques élémentaires destinées à être imprimées individuellement pour reproduire ledit motif, et
- un processeur programmé pour la mise en oeuvre d'un procédé de préparation d'un motif à imprimer tel que défini précédemment.

L'invention sera mieux comprise à l'aide de la description qui va suivre, donnée uniquement à titre d'exemple et faite en se référant aux dessins annexés dans lesquels :
- la figure 1 représente schématiquement la structure générale d'un système de conception de circuit imprimé, selon un mode de réalisation de l'invention, et
- la figure 2 illustre les étapes successives d'un procédé de préparation de motif à imprimer mis en oeuvre par le système de conception de la figure 1.

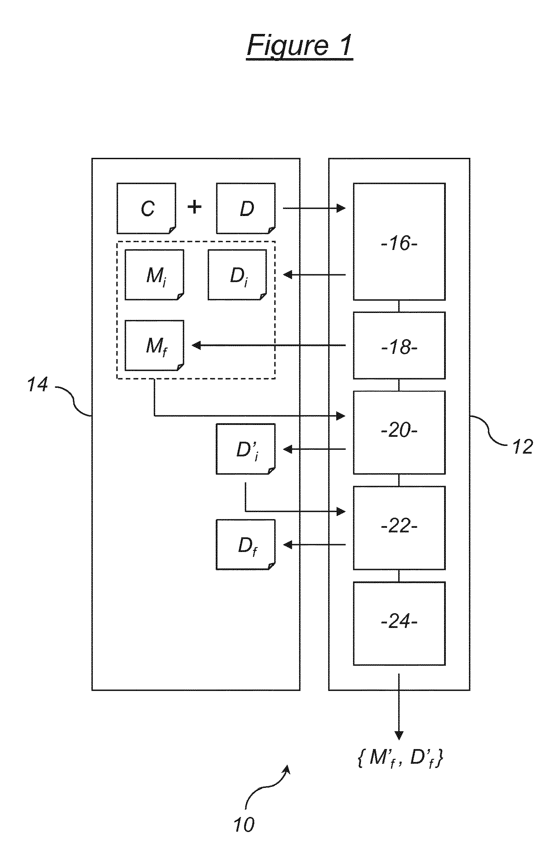

Le système 10 de conception de circuit imprimé représenté schématiquement sur la figure 1 comporte un module de traitement 12 associé de façon classique à une mémoire 14 (par exemple une mémoire RAM). Il peut par exemple être mis en oeuvre dans un dispositif informatique tel qu'un ordinateur classique comportant un processeur associé à une ou plusieurs mémoires pour le stockage de fichiers de données et de programmes d'ordinateur. Le module de traitement 12 peut alors lui-même être considéré comme formé d'un processeur associé à une mémoire de stockage des instructions qu'il exécute sous forme de programmes d'ordinateur.

Le module de traitement 12 tel qu'illustré sur la figure 1 comporte ainsi fonctionnellement cinq programmes d'ordinateur 16, 18, 20, 22 et 24.

Le premier programme d'ordinateur 16 est un programme de modélisation préalable d'un motif donné dont les paramètres de contour sont par exemple stockés en mémoire 14. A partir du contour C du motif à imprimer et éventuellement d'une table D de valeurs discrètes de doses incluant plusieurs valeurs de doses non nulles prédéterminées également enregistrées en mémoire 14, ce premier programme 16 est conçu pour fournir un ensemble théorique de formes géométriques Mᵢ de dimensions différentes modélisant le motif et un ensemble associé de doses théoriques Dᵢ choisies par exemple parmi les valeurs discrètes de doses de la table D. Par « dose », on entend une quantité de charges électriques à appliquer au faisceau d'électrons lors de l'impression individuelle de la forme géométrique qui lui est associée. Cette dose peut être définie sous la forme d'une densité de charges électriques exprimée en nombre de charges par unité de surface, par exemple en µC/cm². Pour compenser le fait que les doses doivent être choisies dans la table D de valeurs discrètes, l'ensemble théorique Mᵢ comporte un grand nombre de formes géométriques dont certaines sont de petites tailles, susceptibles de présenter des dimensions inférieures à 10 nm. On notera qu'en variante et de façon plus générale, les doses théoriques Dᵢ choisies lors de l'exécution du programme d'ordinateur 16 peuvent ne pas être discrétisées, c'est-à-dire qu'elles peuvent ne pas être limitées aux valeurs discrètes de doses de la table D.

Le deuxième programme d'ordinateur 18 est un programme de modélisation du motif donné en un ensemble M_{f} de formes géométriques élémentaires destinées à être imprimées individuellement pour reproduire ledit motif. Il est conçu pour constituer cet ensemble sous la forme d'un pavage bidimensionnel de formes géométriques élémentaires identiques recouvrant le motif à imprimer, incluant donc son contour C. Ces formes élémentaires identiques sont par exemple des carrés de dimensions supérieures aux 10 nm précités et seront par la suite qualifiées de « pixels ».

Le troisième programme d'ordinateur 20 est un programme de pixélisation de l'ensemble théorique Mᵢ sur l'ensemble des formes géométriques élémentaires M_{f}. Cette pixélisation consiste, de façon connue en soi, à déterminer pour chaque pixel de l'ensemble des formes géométriques élémentaires M_{f} une valeur initiale de dose à lui appliquer en fonction des formes géométriques de l'ensemble théorique Mᵢ au moins partiellement recouvertes par ce pixel et de leurs doses théoriques associées. Cette valeur initiale est classiquement déterminée par combinaison linéaire des portions de surfaces des formes géométriques de l'ensemble théorique Mᵢ recouvertes par le pixel considéré pondérées par les doses théoriques qui leur sont associées. L'exécution du programme de pixélisation 20 fournit ainsi un ensemble D'ᵢ de valeurs initiales non discrétisées de doses à affecter à chaque pixel.

Le quatrième programme d'ordinateur 22 est un programme de discrétisation et de correction d'erreur de discrétisation par tramage. Il est conçu pour discrétiser l'ensemble D'ᵢ des valeurs initiales en les approchant chacune par l'une des valeurs discrètes de la table D tout en corrigeant les erreurs de discrétisation induites à l'aide d'un algorithme de tramage quelconque. D'une façon générale, la correction par tramage se fait en rendant aléatoires les erreurs de discrétisation. Avantageusement, le tramage peut être réalisé par un algorithme qui minimise les erreurs de discrétisation. Avantageusement également, le tramage peut être réalisé par diffusion des erreurs de discrétisation à l'aide d'une matrice prédéterminée de diffusion d'erreur. On exécute pour cela par exemple l'algorithme de Floyd-Steinberg dont la matrice de diffusion d'erreur sur un pixel présente les coefficients 7/16 pour le pixel situé au dessus, 1/16 pour celui situé au-dessus à droite, 5/16 pour celui situé à droite et 3/16 pour celui situé en dessous à droite, en parcourant les pixels de bas en haut et de gauche à droite lors de la discrétisation des valeurs initiales de doses et de la correction des erreurs. On fournit ainsi un ensemble de doses finales D_{f} discrétisées à appliquer aux pixels de l'ensemble M_{f}.

Pour éviter des effets indésirables de déformation du motif dans le sens du parcours choisi, on peut réaliser deux parcours successifs lors de la discrétisation et de la diffusion des erreurs : par exemple de bas en haut et de gauche à droite pour le premier parcours lors duquel la moitié des erreurs de discrétisation est corrigée à chaque fois, puis de haut en bas et de droite à gauche pour le second parcours lors duquel l'autre moitié des erreurs de discrétisation est corrigée à chaque fois. De façon pratique, cela peut se faire en utilisant un pas de discrétisation deux fois plus important dans un sens que dans l'autre. En variante, plutôt que de corriger seulement la moitié des erreurs de discrétisation à chaque parcours, on peut utiliser des pavages de pixels de tailles différentes à l'occasion des deux parcours, ou tout simplement décaler le pavage des pixels d'un parcours à l'autre.

Enfin, le cinquième programme d'ordinateur 24 est un programme de regroupement de pixels voisins dont les doses finales discrétisées sont identiques, en des formes géométriques de tailles plus importantes destinées chacune à être imprimées en une seule exposition au faisceau d'électrons. Le résultat de ce regroupement peut éventuellement être associé à des formes complexes prédéterminées de projection, par exemple prioritairement des rectangles. Cette option est simplifiée du fait que le modèle de motif retenu pour l'exécution du deuxième programme 18 est lui-même spatialement largement discrétisé. Le cinquième programme 24 est donc conçu pour fournir un ensemble de pixels regroupés M'_{f}, éventuellement en formes prédéterminées de projection, et un ensemble associé de doses finales discrétisées regroupées D'_{f}.

On notera par ailleurs que les programmes d'ordinateur 16, 18, 20, 22 et 24 sont présentés comme distincts, mais cette distinction est purement fonctionnelle. Ils pourraient tout aussi bien être regroupés en un ou plusieurs logiciels. Leurs fonctions pourraient aussi être au moins en partie micro programmées ou micro câblées dans des circuits intégrés dédiés. Ainsi, en variante, le dispositif informatique mettant en oeuvre le système de conception 10 pourrait être remplacé par un dispositif électronique composé uniquement de circuits numériques (sans programme d'ordinateur) pour la réalisation des mêmes actions.

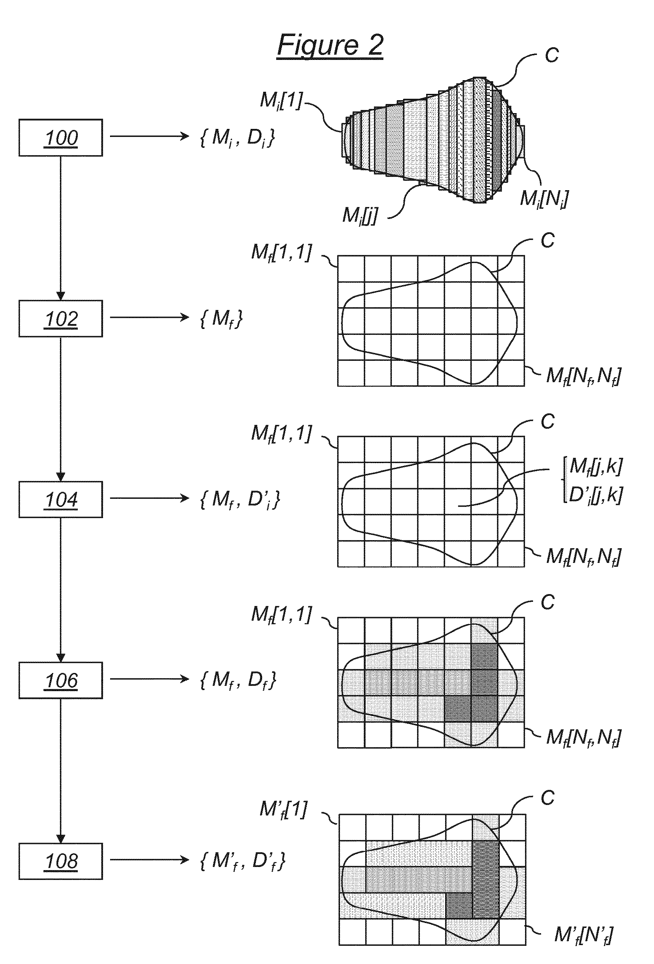

Le procédé de préparation d'un motif à imprimer illustré sur la figure 2 et mis en oeuvre par le module de traitement 12 sur exécution des programmes 16, 18, 20, 22 et 24 comporte une première étape 100, plus précisément réalisée par exécution du premier programme d'ordinateur 16, de modélisation préalable du motif à imprimer. Cette modélisation préalable est réalisée à partir du contour C et éventuellement de la table D de valeurs discrètes de doses, ces données étant préalablement stockées en mémoire 14. Elle fournit les ensembles théoriques associés Mᵢ et Dᵢ qui sont à leur tour stockés en mémoire 14. On note sur la figure 2 que les formes géométriques rectangulaires Mᵢ[1], ..., Mᵢ[Nᵢ] retenues pour modéliser préalablement le motif de contour C sont nombreuses et de tailles très diverses. Certaines, telles que la forme géométrique portant la référence Mᵢ[j], sont de petite taille, pouvant même présenter des dimensions inférieures à 10 nm, ce qui n'est pas propre à permettre une impression précise de cette forme, et donc finalement du motif, par lithographie, et ce qui allonge le temps d'exposition à dose constante du faisceau d'électrons.

Au cours d'une deuxième étape 102 de modélisation du motif, réalisée par exécution du deuxième programme d'ordinateur 18, l'ensemble M_{f} de formes géométriques élémentaires est généré et stocké en mémoire 14. Chaque forme géométrique élémentaire Mᵢ[1,1], ..., M_{f}[N_{f}, N_{f}] de cet ensemble prend la forme d'un pixel.

Au cours d'une troisième étape 104 de pixélisation, réalisée par exécution du troisième programme d'ordinateur 20 sur la base des ensembles Mᵢ, M_{f} et Dᵢ, l'ensemble D'ᵢ de valeurs initiales de doses à affecter à chaque pixel est généré et stocké en mémoire 14 en association avec l'ensemble de formes géométriques élémentaires M_{f}.

Au cours d'une quatrième étape 106 de discrétisation et tramage, réalisée par exécution du quatrième programme d'ordinateur 22 sur la base des ensembles M_{f}, D'ᵢ et de la table D de valeurs discrètes de doses, l'ensemble D_{f} de doses finales discrétisées à affecter à chaque pixel est généré et stocké en mémoire 14 en association avec l'ensemble de formes géométriques élémentaires M_{f}. A titre de simple illustration non limitative, quatre niveaux de discrétisation sont représentés sur la figure 2 à cette étape 106.

Enfin, au cours d'une cinquième étape 108 de regroupement, réalisée par exécution du cinquième programme d'ordinateur 24 sur la base des ensembles M_{f} et D_{f}, les ensembles regroupés M'_{f} et D'_{f} sont générés et stockés en mémoire 14. Le regroupement de pixels permet de fortement réduire le nombre d'expositions successives au faisceau d'électrons, ce qui a pour conséquence directe de réduire le temps global d'exposition de façon très significative. Ainsi, dans l'exemple illustré sur la figure 2, les quatre niveaux de discrétisation permettent certains regroupements de pixels voisins en rectangles de deux, trois ou quatre pixels. Si l'on considère les pixels blancs comme non exposés, le regroupement des pixels dans l'exemple de la figure 2 permet de passer de vingt-deux expositions successives en sortie de l'étape 106 à seulement neuf expositions successives en sortie de l'étape 108.

On notera que dans la mise en oeuvre de l'invention, les exécutions des étapes 100 et 108 sont optionnelles.

On notera également que dans l'exécution des étapes 100 et 106, c'est la même table D de valeurs discrètes de doses qui est utilisée dans l'exemple ci-dessus. Mais dans des modes de réalisation différents de l'invention, il pourrait être utilisé plusieurs tables différentes de valeurs discrètes.

En particulier et avantageusement, la table de valeurs discrètes utilisée lors de l'étape 100 pour réaliser la modélisation préalable n'a aucune raison particulière d'être la même que la table de valeurs discrètes utilisée lors de l'étape 106 de discrétisation et tramage. En effet, la table de valeurs discrètes de doses utilisée pour l'étape 106 de discrétisation et tramage pourrait être plus grossière (i.e. à nombre plus limité de valeurs discrètes de doses) que la table utilisée à l'étape 100 de modélisation préalable, de manière à optimiser le regroupement des pixels à l'étape 108. En outre, en variante et comme cela a été souligné précédemment lors de la description du fonctionnement du programme d'ordinateur 16 et du déroulement de l'étape 100, l'utilisation d'une table de valeurs discrètes de doses n'est pas indispensable à l'étape 100, les doses théoriques Dᵢ pouvant alors être choisies totalement librement sans discrétisation.

Par ailleurs, il pourrait même être utilisé plusieurs tables de valeurs discrètes lors de l'étape 106. En effet, une table grossière pourrait être utilisée pour les pixels situés complètement à l'intérieur du contour C, tandis qu'une table plus fine à nombre plus important de valeurs discrètes de doses pourrait être utilisée pour les pixels situés sur le contour, là où les pixels contribuent plus fortement au bon positionnement du contour lors de l'impression par lithographie.

Il apparaît clairement qu'un système de conception de circuit imprimé et qu'un procédé de préparation de motif à imprimer tels que ceux décrits précédemment permettent de modéliser un motif à imprimer sur plaque ou sur masque par lithographie à faisceau d'électrons à l'aide d'un nombre limité de formes géométriques élémentaires spatialement discrétisées, ce qui a pour conséquence directe de réduire sensiblement le temps global d'exposition du modèle au faisceau d'électrons pour reproduire le motif souhaité sur plaque ou sur masque. L'apport de l'invention est d'autant plus visible en termes de gain de temps et de précision que le motif est lui-même de contour complexe, pourvu que la taille des pixels soit optimisée par rapport à la largeur du faisceau d'électrons et à la taille du plus petit élément de motif à exposer.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

## Revendications

1. Procédé de préparation d'un motif (C) à imprimer sur plaque ou sur masque par lithographie à faisceau d'électrons, comportant les étapes suivantes :
- modélisation (102) du motif par décomposition de ce motif en un ensemble (M_{f}) de formes géométriques élémentaires (M_{f}[1,1], ..., M_{f}[N_{f}, N_{f}]) destinées à être imprimées individuellement pour reproduire ledit motif, et enregistrement du modèle obtenu en mémoire (14),
- pour chaque forme géométrique élémentaire du modèle, détermination (104, 106), par un processeur (12) ayant accès à la mémoire (14), d'une dose de charges électriques à appliquer au faisceau d'électrons lors de l'impression individuelle de cette forme géométrique élémentaire, cette dose étant choisie dans un ensemble discret (D) de doses incluant plusieurs doses non nulles prédéterminées enregistrées en mémoire (14),
dans lequel l'ensemble de formes géométriques élémentaires (M_{f}[1,1], ..., M_{f}[N_{f}, N_{f}]) est un pavage bidimensionnel de formes géométriques élémentaires identiques recouvrant le motif (C) à imprimer, et **caractérisé en ce que** lors de la détermination (104, 106) des doses à appliquer aux formes géométriques élémentaires, une correction d'erreur de discrétisation (106) est réalisée par tramage.

2. Procédé de préparation d'un motif à imprimer selon la revendication 1, comportant en outre une étape (108) de regroupement de formes géométriques élémentaires voisines dont les doses sont identiques, en des formes géométriques de tailles plus importantes destinées chacune à être imprimées en une seule exposition au faisceau d'électrons.

3. Procédé de préparation d'un motif à imprimer selon la revendication 1 ou 2, comportant en outre une étape (100) de modélisation préalable du motif (C) par décomposition de ce motif en un ensemble théorique (Mᵢ) de formes géométriques de dimensions différentes associées respectivement à un ensemble (Dᵢ) de doses théoriques, et dans lequel, lors de la détermination (104, 106) des doses à appliquer au pavage des formes géométriques élémentaires, une pixélisation préalable (104) de l'ensemble théorique (Mᵢ) sur l'ensemble (M_{f}) des formes géométriques élémentaires (M_{f}[1,1], ..., M_{f}[N_{f}, N_{f}]) est exécutée pour déterminer des valeurs initiales (D'ᵢ) des doses à appliquer aux formes géométriques élémentaires.

4. Procédé de préparation d'un motif à imprimer selon la revendication 3, dans lequel un ensemble discret de doses est utilisé lors de l'étape (100) de modélisation préalable pour déterminer les doses théoriques (Dᵢ), cet ensemble discret de doses étant différent de celui utilisé lors de la détermination (104, 106) des doses à appliquer aux formes géométriques élémentaires, notamment cet ensemble comportant moins de valeurs discrètes de doses.

5. Procédé de préparation d'un motif à imprimer selon la revendication 3 ou 4, dans lequel la détermination (104, 106) des doses à appliquer aux formes géométriques élémentaires comporte une comparaison (106) des valeurs initiales de doses à l'ensemble discret des doses prédéterminées enregistrées en mémoire, un choix (106) de doses parmi cet ensemble discret et ladite correction (106) par tramage des erreurs induites par ce choix.

6. Procédé de préparation d'un motif à imprimer selon l'une quelconque des revendications 1 à 5, dans lequel les doses prédéterminées sont définies sous la forme d'une densité de charges électriques exprimée en nombre de charges par unité de surface.

7. Procédé de préparation d'un motif à imprimer selon l'une quelconque des revendications 1 à 6, dans lequel la correction par tramage (106) est réalisée à l'aide d'une matrice prédéterminée de diffusion d'erreur, notamment la matrice de diffusion de l'algorithme de Floyd-Steinberg.

8. Procédé de préparation d'un motif à imprimer selon l'une quelconque des revendications 1 à 7, dans lequel, lors de la détermination (104, 106) des doses à appliquer aux formes géométriques élémentaires :
- un premier ensemble discret de doses prédéterminées enregistrées en mémoire, dit ensemble grossier, est utilisé pour les formes géométriques élémentaires situées à l'intérieur du motif à imprimer, et
- un deuxième ensemble discret de doses prédéterminées enregistrées en mémoire, dit ensemble fin et comportant davantage de valeurs discrètes de doses que l'ensemble grossier, est utilisé pour les formes géométriques élémentaires situées sur le contour du motif à imprimer.

9. Programme d'ordinateur (16, 18, 20, 22, 24) téléchargeable depuis un réseau de communication et/ou enregistré sur un support lisible par ordinateur et/ou exécutable par un processeur (12), **caractérisé en ce qu'il** comprend des instructions pour l'exécution des étapes d'un procédé de préparation d'un motif à imprimer par lithographie à faisceau d'électrons selon l'une quelconque des revendications 1 à 8, lorsque ledit programme est exécuté sur un ordinateur.

10. Système (10) de conception de circuit imprimé par impression de motifs sur plaque ou sur masque à l'aide d'une lithographie à faisceau d'électrons, **caractérisé en ce qu'**il comporte :
- une mémoire (14) de stockage de paramètres de modélisation d'un motif (C) par un ensemble de formes géométriques élémentaires (M_{f}[1,1], ..., M_{f}[N_{f}, N_{f}]) destinées à être imprimées individuellement pour reproduire ledit motif, et
- un processeur (12) programmé pour la mise en oeuvre d'un procédé de préparation d'un motif à imprimer selon l'une quelconque des revendications 1 à 8.

## Patentansprüche

1. Verfahren zum Vorbereiten eines Motivs (C) zum Drucken auf eine Platte oder Maske mittels Elektronenstrahllithographie, die folgenden Schritte umfassend:
- Modellieren (102) des Motivs durch Zerlegen dieses Motivs in eine Menge (M_{f}) an elementaren geometrischen Formen (M_{f}[1, 1], ..., M_{f}[N_{f}, N_{f}]), die dazu bestimmt sind, zur Wiedergabe des besagten Motivs einzeln gedruckt zu werden, und Speichern des erhaltenen Modells im Speicher (14),
- Für jede elementare geometrische Form des Modells, das Bestimmen (104, 106) einer Dosis an elektrischen Ladungen, die beim Einzeldruck dieser elementaren geometrischen Form auf den Elektronenstrahl anzuwenden ist, durch einen Prozessor (12), der auf den Speicher (14) zugreifen kann, wobei diese Dosis aus einer diskreten Menge (D) an Dosen ausgewählt wird, die mehrere vorbestimmte Dosen ungleich Null enthält, die im Speicher (14) abgelegt sind,
wobei die Menge an elementaren geometrischen Formen (M_{f}[1, 1], ... , M_{f}[N_{f}, N_{f}]) eine zweidimensionale Parkettierung identischer elementarer geometrischer Formen ist, die das zu druckende Motiv (C) abdeckt, und **dadurch gekennzeichnet, dass** beim Bestimmen (104, 106) der auf die elementaren geometrischen Formen anzuwendenden Dosen eine Diskretisierungsfehler-Korrektur (106) mittels Rasterung erfolgt.

2. Verfahren zum Vorbereiten eines zu druckenden Motivs nach Anspruch 1, das darüber hinaus einen Schritt (108) zum Zusammenschließen benachbarter elementarer geometrischer Formen umfasst, deren Dosen identisch sind, in geometrische Formen, die größer sind, und die jeweils dazu bestimmt sind, gedruckt zu werden, indem sie dem Elektronenstrahl nur einmal ausgesetzt werden.

3. Verfahren zum Vorbereiten eines zu druckenden Motivs nach Anspruch 1 oder 2, das darüber hinaus einen Schritt (100) zum vorherigen Modellieren des Motivs (C) durch Zerlegen dieses Motivs in eine theoretische Menge (Mᵢ) an geometrischen Formen unterschiedlicher Abmessung umfasst, die jeweils einer Menge (Dᵢ) an theoretischen Dosen zugeordnet werden, und wobei beim Bestimmen (104, 106) der Dosen, die auf die Parkettierung der elementaren geometrischen Formen anzuwenden sind, zuvor eine Pixelierung (104) der theoretischen Menge (Mᵢ) aus der Menge (M_{f}) an elementaren geometrischen Formen (M_{f}[1, 1], ..., M_{f}[N_{f}, N_{f}]) vorgenommen wird, um die anfänglichen Werte (D'ᵢ) für die Dosen zu bestimmen, die auf die elementaren geometrischen Formen anzuwenden sind.

4. Verfahren zum Vorbereiten eines zu druckenden Motivs nach Anspruch 3, wobei beim Schritt (100) zur vorherigen Modellierung zum Bestimmen der theoretischen Dosen (Dᵢ) eine diskrete Menge an Dosen verwendet wird, wobei sich diese diskrete Menge an Dosen von jener unterscheidet, die beim Bestimmen (104, 106) der Dosen verwendet wird, die auf die elementaren geometrischen Formen anzuwenden sind, wobei diese Menge vor allem weniger diskrete Dosiswerte umfasst.

5. Verfahren zum Vorbereiten eines zu druckenden Motivs nach Anspruch 3 oder 4, wobei das Bestimmen (104, 106) der Dosen, die auf die elementaren geometrischen Formen anzuwenden sind, einen Vergleich (106) der anfänglichen Dosiswerte mit der diskreten Menge an vorbestimmten Dosen umfasst, die im Speicher abgelegt ist, eine Auswahl (106) an Dosen aus dieser diskreten Menge und der besagten Korrektur (106) mittels Rasterung jener Fehler, die sich aus dieser Wahl ergeben.

6. Verfahren zum Vorbereiten eines zu druckenden Motivs nach irgendeinem der Ansprüche 1 bis 5, wobei die vorbestimmten Dosen in Form einer Dichte der elektrischen Ladung definiert werden, die in Anzahl der Ladungen je Oberflächeneinheit ausgedrückt wird.

7. Verfahren zum Vorbereiten eines zu druckenden Motivs nach irgendeinem der Ansprüche 1 bis 6, wobei die Korrektur mittels Rasterung (106) anhand einer vorbestimmten Fehlerverteilungsmatrix durchgeführt wird, vor allem aber anhand der Verteilungsmatrix laut Floyd-Steinberg-Algorithmus.

8. Verfahren zum Vorbereiten eines zu druckenden Motivs nach irgendeinem der Ansprüche 1 bis 7, wobei beim Bestimmen (104, 106) der Dosen, die auf die elementaren geometrischen Formen anzuwenden sind:
- eine erste diskrete Menge an im Speicher abgelegten vorbestimmten Dosen, die grobe Menge genannt wird, für die elementaren geometrischen Formen verwendet wird, die sich im Inneren des zu druckenden Motivs befinden, und
- eine zweite diskrete Menge an im Speicher abgelegten vorbestimmten Dosen, die feine Menge genannt wird, und mehr diskrete Werte umfasst, als die grobe Menge, für die elementaren geometrischen Formen verwendet wird, die sich an der Kontur des zu druckenden Motivs befinden.

9. Computerprogramm (16, 18, 20, 22, 24), das aus einem Kommunikationsnetzwerk heruntergeladen und/ oder auf einem Support gespeichert werden kann, das von einem Computer gelesen werden kann und/ oder durch einen Prozessor (12) ausführbar ist, **dadurch gekennzeichnet, dass** es Befehle zur Ausführung der Schritte eines Verfahrens zum Vorbereiten eines zu druckenden Motivs mittels Elektronenstrahllithographie nach irgendeinem der Ansprüche 1 bis 8 umfasst, wenn das besagte Programm auf einem Computer ausgeführt wird.

10. System (10) zum Gestalten von Leiterplatten durch Drucken von Motiven auf eine Platte oder Maske mittels Elektronenstrahllithographie, **dadurch gekennzeichnet, dass** es folgendes umfasst:
- einen Speicher (14) zum Ablegen von Modellierungsparametern eines Motivs (C) durch eine Menge an elementaren geometrischen Formen (M_{f}[1, 1], ..., M_{f}[N_{f}, N_{f}]), die dazu bestimmt sind, einzeln gedruckt zu werden, um das besagte Motiv wiederzugeben, und
- einen Prozessor (12), der für die Umsetzung eines Verfahrens zum Vorbereiten eines zu druckenden Motivs nach irgendeinem der Ansprüche 1 bis 8 programmiert ist.

## Claims

1. Method for preparing a pattern (C) to be printed on a plate or mask by electron beam lithography, comprising the following steps:
- modelling (102) of the pattern by breaking down this pattern into a set (M_{f}) of elementary geometric shapes (M_{f}[1,1], ..., M_{f}[N_{f}, N_{f}]) intended to be printed individually in order to reproduce said pattern, and recording of the model obtained in memory (14), and
- for each elementary geometric shape of the model, determination (104, 106), by a processor (12) having access to the memory (14), of a dose of electrical charges to be applied to the electron beam during the individual printing of this elementary geometric shape, this dose being chosen from a discrete set (D) of doses that includes several predetermined non-zero doses recorded in memory (14),
wherein the set of elementary geometric shapes (M_{f}[1,1], ..., M_{f}[N_{f}, N_{f}]) is a bidimensional paving of identical elementary geometric shapes covering the pattern (C) to be printed, and **characterized in that**, when the doses to be applied to the geometric shapes are determined (104, 106), a discretisation error correction (106) is performed by dithering.

2. Method for preparing a pattern to be printed according to claim 1, further comprising a step (108) of grouping together adjacent elementary geometric shapes the doses of which are identical, in geometric shapes of greater sizes each intended to be printed in a single exposure to the electron beam.

3. Method for preparing a pattern to be printed according to claim 1 or 2, further comprising a prior step (100) of modelling the pattern (C) by breaking down this pattern into a theoretical set (Mᵢ) of geometric shapes with different dimensions associated respectively with a set (Dᵢ) of theoretical doses, and wherein, when the doses to be applied to the paving of elementary geometric shapes are determined (104, 106), a prior pixelisation (104) of the theoretical set (Mᵢ) on the set (M_{f}) of elementary geometric shapes (M_{f}[1,1], ..., M_{f}[N_{f}, N_{f}]) is executed in order to determine initial values of doses (D'ᵢ) to be applied to the elementary geometric shapes.

4. Method for preparing a pattern to be printed according to claim 3, wherein a discrete set of doses is used during the prior modelling step (100) in order to determine the theoretical doses (Dᵢ), this discrete set of doses being different from the one used during the determination (104, 106) of the doses to be applied to the elementary geometric shapes, in particular this set comprising fewer discrete dose values.

5. Method for preparing a pattern to be printed according to claim 3 or 4, wherein the determination (104, 106) of the doses to be applied to the elementary geometric shapes comprises a comparison (106) of the initial values of doses with the discrete set of predetermined doses recorded in memory, a selection (106) of doses from this discrete set and said correction (106) by dithering of the errors caused by this selection.

6. Method for preparing a pattern to be printed according to any one of claims 1 to 5, wherein the predetermined doses are defined in the form of an electrical charge density expressed as a number of charges per unit surface.

7. Method for preparing a pattern to be printed according to any one of claims 1 to 6, wherein the correction by dithering (106) is made by means of a predetermined error diffusion matrix, in particular the diffusion matrix of the Floyd-Steinberg algorithm.

8. Method for preparing a pattern to be printed according to any one of claims 1 to 7, wherein, when the doses to be applied to the elementary geometric shapes are determined (104, 106):
- a first discrete set of predetermined doses recorded in memory, referred to as a coarse set, is used for the elementary geometric shapes situated inside the pattern to be printed, and
- a second discrete set of predetermined doses recorded in memory, referred to as the fine set and comprising more discrete values of doses than the coarse set, is used for the elementary geometric shapes situated on the contour of the pattern to be printed.

9. Computer program (16, 18, 20, 22, 24) downloadable from a communication network and/or recorded on a medium that can be read by computer and/or executed by a processor (12), **characterized in that** it comprises instructions for executing the steps of a method for preparing a pattern to be printed by electron beam lithography according to any one of claims 1 to 8, when said program is executed on a computer.

10. System (10) for designing a printed circuit by printing patterns on a plate or mask using electron beam lithography, **characterized in that** it comprises:
- a memory (14) for storing parameters for modelling a pattern (C) by a set of elementary geometric shapes (M_{f}[1,1], ..., M_{f}[N_{f}, N_{f}]) intended to be printed individually in order to reproduce said pattern, and
- a processor (12) programmed for implementing the method for preparing a pattern to be printed according to any one of claims 1 to 8.
